Europäisches Patentamt

European Patent Office

Office européen des brevets

(11) Publication number: **0 101 994**
**B1**

## (12) EUROPEAN PATENT SPECIFICATION

(45) Date of publication of patent specification: **07.05.86**

(21) Application number: **83107834.0**

(22) Date of filing: **09.08.83**

(51) Int. Cl.⁴: **H 05 K 3/00**

(54) **Printed circuit board modification process.**

(30) Priority: **30.08.82 US 412653**

(43) Date of publication of application:
**07.03.84 Bulletin 84/10**

(45) Publication of the grant of the patent:
**07.05.86 Bulletin 86/19**

(84) Designated Contracting States:
**DE FR GB**

(56) References cited:
**DE-C-2 414 509**
**US-A-3 649 273**

(73) Proprietor: **International Business Machines
Corporation
Old Orchard Road
Armonk, N.Y. 10504 (US)**

(72) Inventor: **Hall, Douglas Joe
Route 1 Tiona Road
Newark Valley New York 13811 (US)**
Inventor: **Langley, Robert Francis
500 E. Benita Blvd.
Vestal New York 13850 (US)**
Inventor: **Thomas, Edwin Lewis
5 Berne Drive
Apalachin New York 13732 (US)**

(74) Representative: **Neuland, Johannes, Dipl.-Ing.
et al
Schönaicher Strasse 220
D-7030 Böblingen (DE)**

Courier Press, Leamington Spa, England.

## Description

This invention concerns a process for modifying a glass master having an emulsion pattern of circuit lines and lands to produce a modified printed circuit board having a corresponding circuit pattern.

The making of a multilayer printed circuit board involves a number of process steps, one of which is the making of a glass master which is used to expose the pattern of circuit lines and lands on the circuit board. The glass master is made by taking a photosensitized glass plate and moving it in the X and Y directions under an optical exposure head of a data controlled phototracing machine to trace the circuit pattern on the glass plate which will correspond to the circuit pattern desired on a particular circuit board which is being processed through the production line in substantial quantity. In a multilayer board, each internal circuit plane requires its own related glass master.

It becomes necessary from time to time to modify or change the circuit patterns on the internal circuit planes of a board. Heretofore, two methods have been used to accomplish this. One method was to destroy the old glass master and make a complete new glass master. This proved to be time consuming and costly. It takes about 40 hours to process a photosensitized glass plate through the photo tracing machine. Also, there is generally a waiting period in order to obtain access to the machine which is costly in the loss of production time. The other method was to change the electrical connector in the plated through holes of the board. This connector currently takes the form of the one shown in US Patent 3 915 537. To make a change, this connector had to be removed, the plate hole drilled and an insulating sleeve inserted. Then, a similar connector was inserted having a longer tail which had to be wire bonded externally to a circuit land. This method was costly and presented problems.

The present invention overcomes the aforementioned problems by providing a process for modifying internal circuits in a printed circuit board by modifying the glass master which produces the internal circuit pattern. An inexpensive film copy of the glass master to be changed is used to identify the circuit lands to be removed. A numerically controlled drill forms holes in the film at these locations thereby removing the image of the land and these alternations are verified in accordance with the engineering change instructions. The perforated film is used as a template to alter the glass master by removing the emulsion through the holes in the film and then the glass master is verified and used to produce the modified circuit board.

Features and advantages of the invention will be apparent from the following more particular description of a preferred embodiment of the invention, as illustrated in the accompanying drawings, in which:

Figs. 1—4 are schematic views illustrating various stages of a process for producing a printed circuit board.

Figs. 5—11 are schematic views illustrating the process of the present invention for modifying the printed circuit board made by the process shown in Figs. 1—8.

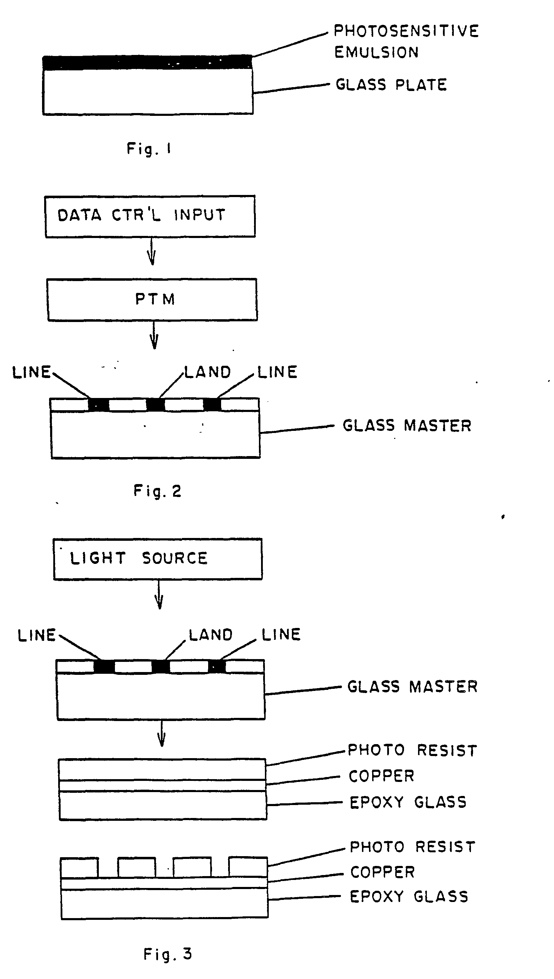

Referring to Fig. 1, there is shown a glass plate having a photosensitive emulsion coated glass plate is then processed in a data controlled photo tracing machine (PTM), as shown in Fig. 2. The desired circuit pattern is designed by product design engineering and is supplied to a suitable computer which provides the data control input. The photo tracing machine comprises briefly an optical exposure head having a light source, condensing and projection lens, and reticles for tracing a configuration, such as lines and lands on the photosensitive glass plate which moves relative to the head. An example of a photo tracing machine of this type is shown in US Patent 3 710 702. As is shown, the silver halide emulsion turns to black where it is exposed to the light trace and the rest of the halide remains silver. In this fashion, the desired glass master is produced.

Referring now to Fig. 3, a light source and the glass master is used to expose the circuit board having an epoxy glass base, a copper coating, and a photo resist coating over the copper. As is known, where the light passes through the glass master, i.e. the undarkened area, the photo resist will become hard. The board is then chemically developed to remove the unexposed resist which leaves a pattern of exposed copper which corresponds to the emulsion pattern on the glass master.

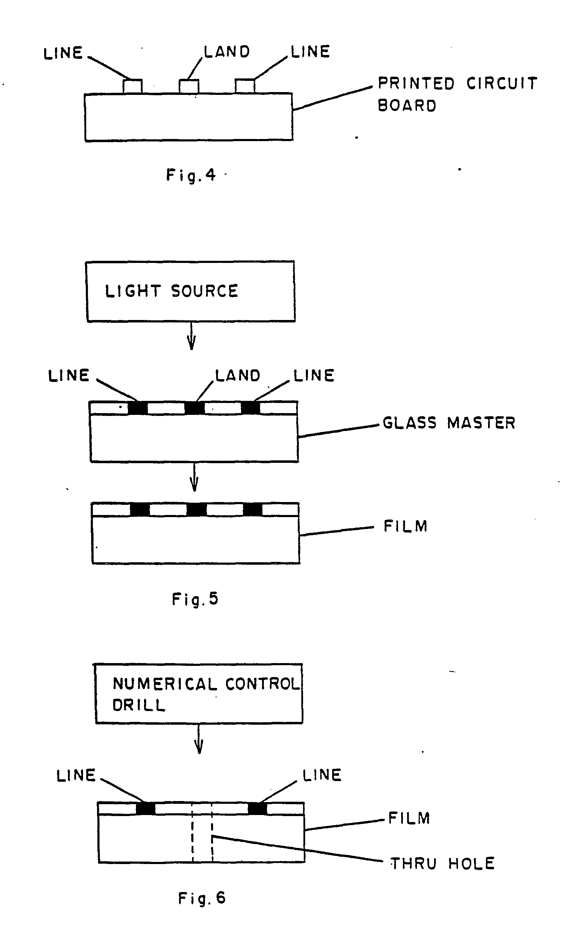

A conventional circuitizing process for the board will be but briefly described. Tin is electroless applied to form an etch resist for the exposed copper. The photo resist is chemically removed and all copper is etched away except that covered by the tin. Then, the tin is etched away which results in the board shown in Fig. 4 which has a pattern of copper circuit lines and lands corresponding to the emulsion pattern on the glass master, shown in Figs. 2 and 3.

Referring to Figs. 5—11, there is illustrated the process of the present invention for modifying or changing a printed circuit board in the production line, such as the one shown in Fig. 4. A determination is made that the board needs a new function or that an error has to be corrected and a decision is made to meet the requirement by deleting a wire embedded in the board. Computerized engineering data is generated in accordance with the change required.

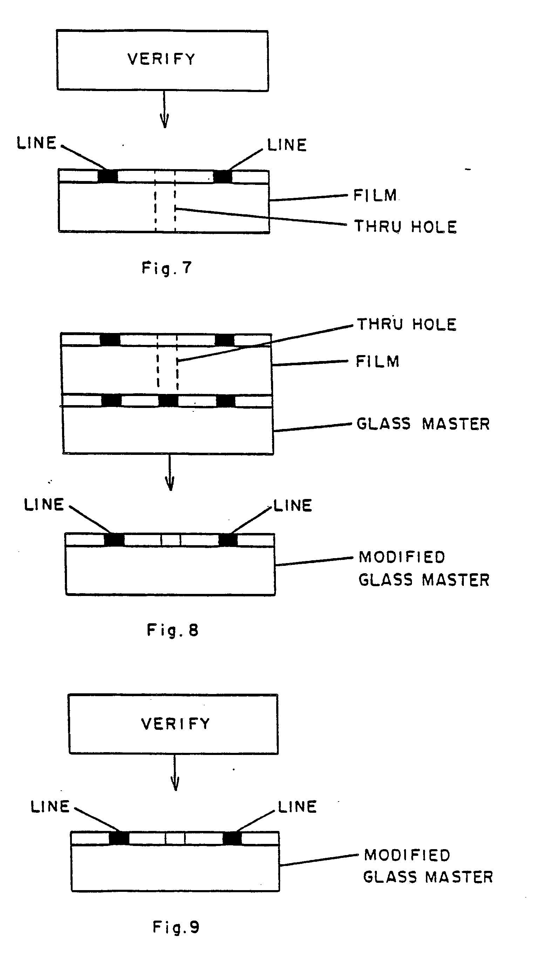

Fig. 5 shows the making of a film of the old glass master (Figs. 2 and 3). Next, as indicated in Fig. 6, a numerically controlled mechanical drill controlled by the engineering change data is used to drill a hole through the film to remove the image of the circuit land to be deleted on the board. Following the drilling operation, the film is verified, as indicated in Fig. 7, by a numerical controlled optical inspection machine which compares the film against the engineering data to determine if the drilled location is correct.

Referring now to Fig. 8, the drilled film is used as a template and it is registered over the glass master with its images in alignment with the emulsion on the glass master. The engineering change data has dictated that the emulsion representing a land and which is in alignment with the hole in the film should be removed in order to make a corresponding delete in the board. This emulsion can be manually removed from the glass master by using a suitable instrument, such as, a stylus or pointed knife. Removal by chemical process is also possible.

Fig. 9 indicates that the modified glass master is also verified by the numerical controlled optical inspection machine used to verify the film.

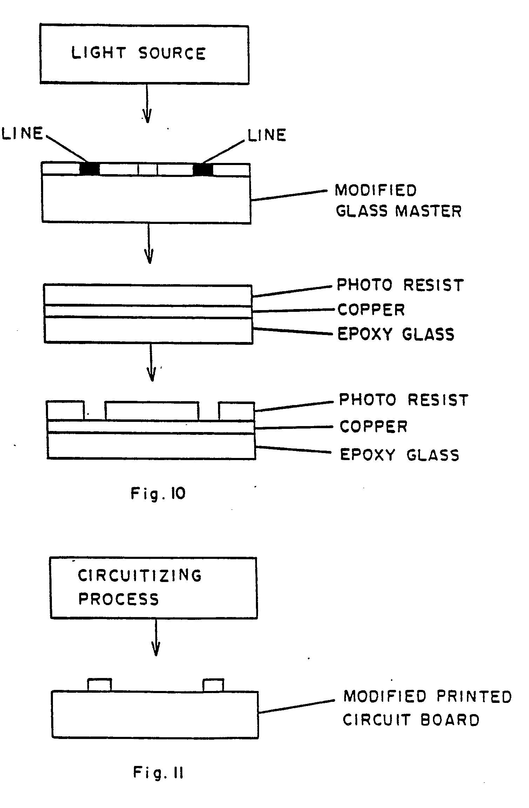

Now, as indicated in Fig. 10, the same expose and developing steps are carried out for the board as was described in connection with Fig. 3, except that now the modified glass master is used.

As indicated in Fig. 11, the board now is circuitized in the same manner as was described above. It will be noted that this board differs in pattern from the board shown in Fig. 4 and has been modified or changed according to engineering change instructions by the deletion of the circuit land. Although the deletion of only one circuit land has been shown for simplicity, a plurality of lands may be deleted by drilling the required holes in the film.

The present process only makes deletions. If both deletions and additions are required, two sets of engineering change instructions are used and the additions can be made by external twisted wire bonding.

Also, only one internal circuit plane has been shown for simplicity. It can be appreciated that in a multilayer board where there are a plurality of internal circuit planes, the use of the previously mentioned prior art methods of either making a complete new glass master for each circuit plane or changing the connectors in the plated through holes is extremely time consuming and costly. The present process wherein the old glass masters are simply altered results in a substantial reduction in time and savings in cost.

## Claims

1. A process for modifying a glass master having an emulsion pattern of circuit lines and lands to produce a modified printed circuit board having a corresponding circuit pattern characterized by the following steps:

making a film copy of said glass master,

forming holes in said film at land locations to be removed,

registering the film over said glass master with the holes in alignment with the lands to be removed,

removing emulsion from the glass master through said holes, and

using the modified glass master to produce a modified printed circuit board.

2. The modifying process of claim 1, wherein the step of forming holes includes drilling a hole through said film under control of engineering change data to remove the image of a circuit land to be deleted from said circuit board.

3. The modifying process of claim 2, wherein said drilling of a hole in said film is numerically controlled.

4. The modifying process of any preceding claim, further including the steps of optically comparing said film against engineering change data to determine if the location of the formed hole is correct, and optically comparing the modified glass master against the engineering change data to determine if the modification is correct.

## Patentansprüche

1. Verfahren zum Modifizieren einer Glasplatte, die mit einem Emulsionsmuster für Leiterzüge und Anschlußstellen versehen ist, zur Herstellung einer modifizierten gedruckten Schaltkarte mit einem entsprechenden Leitungsmuster, gekennzeichnet durch die folgenden Schritte:

Erstellung einer Filmkopie der Gasplatte,

Einbringen von Öffnungen im Film an den zu entfernenden Anschlußstellen,

Plazieren des Films über der Glasplatte, wobei die Öffnungen mit den zu entfernenden Anschlußstellen auszurichten sind,

Entfernen der Emulsion von der Glasplatte durch die Öffnungen, und

Herstellung einer modifizierten gedruckten Schaltung mittels der modifizierten Glasplatte.

2. Modifizierverfahren nach Anspruch 1, in welchem der Schritt der Öffnungsbildung das Bohren einer Öffnung durch den Film umfasst, gesteuert von technischen Änderungsdaten zur Entfernung der Bildes der Anschlußstelle, welche von der gedruckten Schaltung entfernt werden soll.

3. Modifizierverfahren nach Anspruch 2, in welchem das Bohren einer Öffnung im Film numerisch gesteuert wird.

4. Modifizierverfahren nach einem der vorhergehenden Ansprüche, weiterhin enthaltend einen optischen Vergleich des Films mit den technischen Änderungsdaten, um die korrekte Positionierung der Öffnung zu prüfen, und einen optischen Vergleich der modifizierten Glasplatte mit den technischen Änderungsdaten, um die korrekte Modifikation zu prüfen.

## Revendications

1. Procédé de modification d'un masque maître de verre portant un motif d'émulsion de lignes et de plots de circuit pour produire une carte de circuit imprimé modifiée comportant un motif de circuit correspondant, caractérisé en ce qu'il comprend les étapes suivantes:

faire une copie sous forme d'un film du masque maître de verre,

former des trous dans le film aux emplacements des plots à supprimer,

disposer le film sur le masque maître de verre, les trous étant en alignement avec les plots à enlever,

enlever l'émulsion du masque maître de verre à travers les trous, et

utiliser le masque maître de verre modifié pour produire une carte de circuit imprimé modifiée.

2. Procédé de modification selon la revendication 1, caractérisé en ce que l'étape de formation de trous comprend le perçage d'un trou à travers le film sous la commande de données de changement de fabrication pour enlever l'image d'un plot du circuit à supprimer de la carte de circuit.

3. Procédé de modification selon la revendication 2, caractérisé en ce que le perçage d'un trou dans le film est commandé numériquement.

4. Procédé de modification selon l'une quelconque des revendications précédentes, comprenant en outre les étapes consistant à comparer optiquement le film par rapport aux données de changement de fabrication pour déterminer si l'emplacement du trou formé est correct, et comparer optiquement le masque maître de verre modifié aux données de changement de fabrication pour déterminer si la modification est correcte.

Fig. I

Fig. 2

Fig. 3

1

Fig.4

Fig.5

Fig.6

# 0 101 994

Fig. 7

Fig. 8

Fig. 9

LIGHT SOURCE

LINE — LINE

MODIFIED
GLASS MASTER

PHOTO RESIST
COPPER
EPOXY GLASS

PHOTO RESIST
COPPER
EPOXY GLASS

Fig. 10

CIRCUITIZING
PROCESS

MODIFIED PRINTED
CIRCUIT BOARD

Fig. 11